# EUROPÄISCHE PATENTSCHRIFT

(11) **EP 2 810 086 B1**
(45) Veröffentlichungstag und Bekanntmachung des Hinweises auf die Patenterteilung: **04.07.2018**
(21) Anmeldenummer: 13702452.7
(22) Anmeldetag: 01.02.2013
(51) Int. Cl.: G01R 13/02, G06T 5/40, H04N 1/407, G06T 5/00, G06T 11/20, G01R 23/16

(54) **MESSVORRICHTUNG UND VERFAHREN ZUR AUTOMATISCHEN ANPASSUNG DES KONTRASTES IN DER BILDSCHIRMDARSTELLUNG**
MEASURING DEVICE AND METHOD FOR AUTOMATIC ADJUSTMENT OF CONTRAST IN THE SCREEN DISPLAY
DISPOSITIF DE MESURE ET PROCÉDÉ D'ADAPTATION AUTOMATIQUE DU CONTRASTE DE LA VISUALISATION À L'ÉCRAN

(30) Priorität: 03.02.2012 DE 102012201619
(43) Veröffentlichungstag der Anmeldung: 10.12.2014
(73) Patentinhaber: Rohde & Schwarz GmbH & Co. KG, 81671 München (DE)
(72) Erfinder: KELLER, Matthias, 85551 Kirchheim (DE); ECKERT, Hagen, 86415 Mering (DE)
(74) Vertreter: Körfer, Thomas
(86) Internationale Anmeldenummer: PCT/EP2013/052030
(87) Internationale Veröffentlichungsnummer: WO 2013/113872

(56) Entgegenhaltungen:
- EP-A2- 0 952 458
- WO-A1-2009/029448
- WO-A2-2009/143466
- DE-A1- 19 958 662
- US-A1- 2003 152 266
- US-B1- 6 240 282
- Wolfgang Buescher: "DL4YHF's Spectrum Laboratory (short: SpecLab) Manual", Spectrum Lab , 7. November 2011 (2011-11-07), Seite 65pp, XP002695498, Gefunden im Internet: URL:http://web.archive.org/web/20111107092 454/http://dl4yhf.ssl7.com/speclab/index.h tm [gefunden am 2013-04-16]
- XU MANKUN ET AL: "A New Time-Frequency Spectrogram Analysis of FH Signals by Image Enhancement and Mathematical Morphology", IMAGE AND GRAPHICS, 2007. ICIG 2007. FOURTH INTERNATIONAL CONFERENCE ON, 1. August 2007 (2007-08-01), Seiten 610-615, XP031131359, IEEE, PISCATAWAY, NJ, USA ISBN: 978-0-7695-2929-5

## Beschreibung

Die Erfindung betrifft eine Messvorrichtung und ein Verfahren zur automatischen Anpassung eines Kontrastes einer Vielzahl von aufgenommenen Messwerten, insbesondere in einer Spektrogrammdarstellung.

In Spektrogrammen findet die Darstellung des zeitlichen Verlaufes des Leistungsspektrums eines Signals statt. Bevorzugt wird der zeitliche Verlauf des Signals auf der vertikalen Achse dargestellt, wohingegen auf der horizontalen Achse eine spektrale Einzelmessung abgebildet wird. Die Pegelwerte können dabei beispielsweise farblich kodiert sein. Neue Messwerte werden bevorzugt in der obersten Zeile eingefügt und die restlichen Messwerte um jeweils eine Zeile nach unten verschoben, woher auch der Name "Wasserfalldiagramm" kommt.

In der Zeitschrift "NEUES 203/11" von Rohde & Schwarz, ISSN 0548-3093, 2011, ist auf den Seiten 50 und 51 ein Spektrum und ein Wasserfalldiagramm von einem aufgenommenen Radarsignal dargestellt. Nachteilig dabei ist, dass das eigentliche Radarsignal aufgrund seines geringen Leistungspegels nur schlecht vom Hintergrundrauschen zu unterscheiden ist. Weiter ist ein Softwareprogramm Spectrum Lab, 07-11-2011 Wolfgang Buescher: "DL4YHF's Spectrum Laboratory (short: SpecLab) Manual",XP002695498, aus dem Internet,http://web.archive.org/web/20111107092454/ http://dl4yhf.ssl7.com/speclab/index.htm bekannt. Es ist daher die Aufgabe der Erfindung, eine Messvorrichtung und ein Verfahren mit der Möglichkeit zu schaffen, das eigentliche Nutzsignal für den Betrachter optisch besser darzustellen.

Die Aufgabe wird bezüglich der erfindungsgemäßen Messvorrichtung durch die Merkmale des Anspruchs 1 und bezüglich des erfindungsgemäßen Verfahrens durch die Merkmale des Anspruchs 9 gelöst. Der Anspruch 17 beinhaltet ein Computerprogramm mit Programmcode-Mitteln, um sämtliche Verfahrensschritte ausführen zu können, wenn das Programm auf einem Computer oder einem digitalen Signalprozessor ausgeführt wird. Der Anspruch 18 enthält ein Computerprogramm-Produkt mit insbesondere auf einem maschinenlesbaren Träger gespeicherten Programmcode-Mitteln, um alle Verfahrensschritte durchführen zu können, wenn das Programm auf einem Computer oder einem digitalen Signalprozessor ausgeführt wird. In den jeweiligen Unteransprüchen sind vorteilhafte Weiterbildungen der erfindungsgemäßen Messvorrichtung und des erfindungsgemäßen Verfahrens angegeben.

Die erfindungsgemäße Messvorrichtung dient zur Erhöhung eines Kontrasts der Darstellung einer Vielzahl in einem Spektrogramm oder spektralen Histogramm dargestellten Messwerte und weist eine Erfassungseinheit, eine Recheneinheit und eine Statistikeinheit auf, wobei die Erfassungseinheit ausgebildet ist, um eine Vielzahl darzustellender Messwerte zu erfassen, wobei die Statistikeinheit ausgebildet ist, um eine Verteilung zu berechnen, die die Auftritts-Häufigkeit für jeden Pegelwert der darzustellenden Messwerte beinhaltet und wobei eine Recheneinheit ausgebildet ist, um einen Dynamikbereich, über den sich der Kontrast erstreckt festzulegen, wobei ein festgelegter Anteil derjenigen Pegelwerte, die das Rauschen abbilden, nicht zur Festlegung des Dynamikbereichs verwendet wird.

Es ist besonders vorteilhaft, dass eine Auftritts-Häufigkeit für jeden Pegelwert der darzustellenden Messwerte berechnet wird. Anhand dieser Auftritts-Häufigkeit kann sehr gut erkannt werden, wie häufig bestimmte Pegelwerte innerhalb des Spektrogramms oder spektralen Histogramms auftreten, wobei gezielt diejenigen Pegelwerte nicht zur Einstellung des Kontrasts verwendet werden, die das Rauschen abbilden. Der Kontrast, der sich beispielsweise von einer sehr dunklen Farbe hin zu einer sehr hellen Farbe erstrecken kann, umfasst folglich nicht mehr diejenigen Messwerte, die das Rauschen darstellen. Dies bedeutet, dass das eigentliche Signal deutlich gegenüber denjenigen Messwerten hervorgehoben wird, die das Rauschen abbilden. Es ist dabei nicht von Bedeutung, wie hoch der eigentliche Signalpegel ist, solange das Rauschen nicht zur Festlegung des Dynamikbereichs für den Kontrast herangezogen wird.

Das erfindungsgemäße Verfahren dient zur Erhöhung eines Kontrasts von einer Vielzahl in einem Spektrogramm oder spektralen Histogramm dargestellten Messwerte. Innerhalb des Verfahrens werden eine Vielzahl von Verfahrensschritten ausgeführt, wobei zu Beginn eine Vielzahl an darzustellenden Messwerten erfasst wird. Im Anschluss daran erfolgt eine Berechnung einer Verteilung, die die Auftritts-Häufigkeit für jeden Pegelwert der darzustellenden Messwerte beinhaltet. Schließlich erfolgt ein automatisches Festlegen eines Dynamikbereichs über den sich der Kontrast erstreckt, wobei ein festgelegter Anteil derjenigen Pegelwerte, die das Rauschen abbilden, nicht zur Festlegung des Dynamikbereichs verwendet werden.

Bei dem erfindungsgemäßen Verfahren zur Erhöhung des Kontrasts ist es besonders vorteilhaft, wenn diejenigen Pegelwerte, die das Rauschen abbilden, nicht zur Festlegung eines Dynamikbereichs für den Kontrast verwendet werden. Unter einem Dynamikbereich kann beispielsweise der Farbraum zu verstehen sein, der den Kontrast bildet. Dieser kann sich beispielsweise von sehr dunklen bis hin zu sehr hellen Farben erstrecken. Er kann auch einzig aus Graustufen, bzw. einer oder wenigen Farben bestehen. Bevorzugt wird der Dynamikbereich, über den sich der Kontrast erstreckt, durch Pegelwerte festgelegt, die den eigentlichen Nutzsignal entsprechen. Dadurch wird das eigentliche Nutzsignal gegenüber dem Rauschen besonders stark hervorgehoben und damit optisch besser erkennbar.

Weiterhin liegt ein Vorteil bei der erfindungsgemäßen Messvorrichtung vor, wenn der Dynamikbereich durch die Pegelwerte der empfangenen Messwerte gebildet wird und/oder wenn die Recheneinheit ausgebildet ist, um einzig Pegelwerte beim Festlegen des Dynamikbereichs zu berücksichtigen, deren Auftritts-Häufigkeit und/oder deren Pegelwert über einen einstellbaren Schwellwert liegen und/oder wenn die Recheneinheit ausgebildet ist, um unterschiedliche Pegelwerte, die den Dynamikbereich festlegen, durch unterschiedliche Farben und/oder durch unterschiedliche Graustufen und/oder durch unterschiedliche Helligkeitsabstufungen darzustellen. Es ist besonders vorteilhaft, wenn die Recheneinheit einzig Pegelwerte zum Festlegen des Dynamikbereichs berücksichtigt, deren Auftritts-Häufigkeit und/oder deren Pegelwert über einem einstellbaren Schwellwert liegen. Dies stellt sicher, dass der Dynamikbereich zumindest grob dem darzustellenden Messsignal angepasst wird. Die Tatsache, dass der Dynamikbereich durch unterschiedliche Farben oder durch unterschiedliche Graustufen oder durch unterschiedliche Helligkeitsabstufungen dargestellt wird, ermöglicht, dass das eigentliche Messsignal besonders hervorgehoben wird.

Zusätzlich besteht bei der erfindungsgemäßen Messvorrichtung ein Vorteil, wenn ein Farbverlauf oder ein Graustufenverlauf oder ein Helligkeitsabstufungsverlauf innerhalb des Dynamikbereichs einen linearen oder einen parabelförmigen oder einen exponentiellen oder einen nicht-linearen Verlauf hat. Ein parabellförmiger oder ein exponentieller Verlauf des Dynamikbereichs erlauben beispielsweise, dass Signalanteile, die einen bestimmten Pegelwert überschreiten, deutlich gegenüber den anderen Signalanteilen hervorgehoben werden.

Weiterhin besteht bei der erfindungsgemäßen Messvorrichtung ein Vorteil, wenn die Recheneinheit ausgebildet ist, um eine Änderung einer Auflösebandbreite oder einer Messzeit innerhalb der Messvorrichtung zu erfassen und um den Dynamikbereich, über den sich der Kontrast erstreckt, derart zu verändern, dass sich der Kontrast für die Vielzahl in dem Spektrogramm oder spektralen Histogramm dargestellten Messwerte nicht verändert. Für den Fall, dass die Auflösebandbreite und/oder die Messzeit verändert wird, verschiebt sich die Auftritts-Häufigkeit für jeden Pegelwert und damit auch der dargestellte Farb- oder Helligkeitseindruck. Ohne eine automatische Korrektur des Kontrasts könnte das eigentliche Messsignal nicht mehr richtig erkannt werden.

Schlussendlich besteht bei der erfindungsgemäßen Messvorrichtung ein Vorteil, wenn die Recheneinheit ausgebildet ist, um den Dynamikbereich, über den sich der Kontrast erstreckt, nur über einen oder mehrere Teilbereiche des Spektrogramms oder spektralen Histogramms festzulegen. Dies erlaubt, dass bei Auftreten von mehreren Signalen, die frequenzmäßig voneinander beabstandet sind, der Dynamikbereich einzig von den Pegeln her festgelegt werden, die sich innerhalb eines gewissen Frequenzbereichs befinden, also einem Signal zugeordnet werden. Pegelwerte außerhalb dieses Frequenzbereichs dienen nicht zur Festlegung des Dynamikbereichs und werden nicht hervorgehoben dargestellt. Dadurch kann auch ein schwaches Signal, welches zu einem starken Signal frequenzmäßig benachbart ist, kontraststark dargestellt werden.

Bei dem erfindungsgemäßen Verfahren besteht weiterhin ein Vorteil, wenn in einem weiteren Verfahrensschritt ein erster Pegelwert ermittelt wird, dessen Auftritts-Häufigkeit am höchsten ist. Anschließend kann eine untere Grenze für den Dynamikbereich festgelegt werden, die dem ersten Pegelwert entspricht, oder es kann eine untere Grenze für den Dynamikbereich festgelegt werden, die einem zweiten Pegelwert entspricht, wobei der zweite Pegelwert größer ist, als der erste Pegelwert und wobei ein Abstand zwischen dem ersten Pegelwert und dem zweiten Pegelwert einstellbar ist, oder wenn eine untere Grenze für den Dynamikbereich festgelegt wird, die oberhalb eines niedrigsten Pegelwerts liegt und von diesem durch einen einstellbaren Abstand beabstandet ist. Bei einer breitbandigen Erfassung eines Nutzsignals handelt es sich bei dem Pegelwert, dessen Auftritts-Häufigkeit am höchsten ist, meistens um Rauschen. Indem eine untere Grenze für den Dynamikbereich auf den ersten Pegelwert oder auf einen zweiten Pegelwert, der größer ist als der erste Pegelwert, festgelegt wird, kann ein nennenswerter Anteil des Rauschens abgeschnitten werden, welches im Folgenden nicht mehr für die Festlegung des Dynamikbereichs, über den sich der Kontrast erstreckt, herangezogen wird. Gleiches gilt auch, wenn die untere Grenze oberhalb eines niedrigsten Pegelwerts festgelegt wird.

Außerdem besteht bei dem erfindungsgemäßen Verfahren ein Vorteil, wenn ein weiterer Verfahrensschritt ausgeführt wird, in dem die berechnete Verteilung mit zumindest zwei gespeicherten Verteilungen korreliert wird und in dem der Dynamikbereich, über den sich der Kontrast erstreckt, derart festgelegt wird, dass dieser einem gespeicherten Dynamikbereich entspricht, der mit der gespeicherten Verteilung verknüpft ist, für die das Ergebnis der Korrelation den höchsten Wert aufweist. Es ist hier besonders vorteilhaft, dass die berechnete Verteilung mit bereits bekannten Verteilungen verglichen wird. Für diese bekannten Verteilungen sind bereits Dynamikbereiche hinterlegt, sodass der derjenige hinterlegte Dynamikbereich für die berechnete Verteilung verwendet wird, dessen gespeicherte Verteilung der berechneten Verteilung am Ähnlichsten ist. Dies erlaubt, dass bei bekannten Signalen das Rauschen noch effektiver ausgeblendet wird, sodass das eigentliche Nutzsignal in dem Spektrogramm oder spektralen Histogramm noch deutlicher dargestellt werden kann.

Auch besteht bei dem erfindungsgemäßen Verfahren ein Vorteil, wenn die Vielzahl der in dem Spektrogramm oder spektralen Histogramm dargestellten Messwerte zumindest ein zu analysierendes Signal abbilden und der Dynamikbereich über den sich der Kontrast erstreckt, derart festgelegt wird, dass dieser einem gespeicherten Dynamikbereich entspricht, der mit einem gespeicherten Signal verknüpft ist, wobei das gespeicherte Signal die gleiche Modulationsart und/oder die gleiche Frequenz und/oder die gleiche Bandbreite aufweist, wie das zu analysierende Signal. Es ist hierbei besonders vorteilhaft, dass für den Fall, dass die Art des Signals bekannt ist, direkt ein Dynamikbereich verwendet werden kann, der für das bekannte Signal hinterlegt ist. Dieser Verfahrensschritt kann bevorzugt auch mit dem Verfahrensschritt "Korrelieren" kombiniert werden, sodass die berechnete Verteilung einzig mit gespeicherten Verteilungen korreliert wird, deren Signale die gleiche Modulationsart und/oder die gleiche Frequenz und/oder die gleiche Signal-Bandbreite und/oder Auflöse-Bandbreite aufweisen.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Ausführungsbeispiel einer erfindungsgemäßen Messvorrichtung zur Erhöhung eines Kontrasts von anzuzeigenden Messwerten;
- Fig. 2: ein Spektrogramm, in welchem die erfassten Messwerte angezeigt sind, eine Verteilung, die die Auftritts-Häufigkeit der einzelnen Pegelwerte angibt und einen Dynamikbereich, der den Kontrast bestimmt;
- Fig. 3: ein Spektrogramm, in welchem die erfassten Messwerte mit einem höheren Kontrast angezeigt sind, eine Verteilung, die die Auftritts-Häufigkeit der einzelnen Pegelwerte angibt, und einen eingeschränkten Dynamikbereich;
- Fig. 4: ein Spektrogramm, in welchem die erfassten Messwerte mit einem noch höheren Kontrast angezeigt sind, eine Verteilung, die die Auftritts-Häufigkeit der einzelnen Pegelwerte angibt, und einen weiteren eingeschränkter Dynamikbereich;
- Fig. 5A: eine Verteilung, die die Auftritts-Häufigkeit der einzelnen Pegelwerte angibt, und einen Dynamikbereich, der das Rauschen ausschließt;
- Fig. 5B: eine weitere Verteilung, die die Auftritts-Häufigkeit der einzelnen Pegelwerte angibt und einen Dynamikbereich, der das Rauschen ausschließt;
- Fig. 6: ein Flussdiagramm eines Ausführungsbeispiels des erfindungsgemäßen Verfahrens, das erläutert, dass der Kontrast für die aufgenommenen Messwerte derart gewählt wird, dass diejenigen Messwerte, die das Rauschen abbilden, nicht mit erfasst sind;
- Fig. 7: ein Flussdiagramm eines Ausführungsbeispiels des erfindungsgemäßen Verfahrens, das beschreibt, wie die Grenzen des Dynamikbereichs gewählt werden, der den Kontrast bestimmt;
- Fig. 8: ein weiteres Flussdiagramm eines Ausführungsbeispiels des erfindungsgemäßen Verfahrens, das beschreibt, wie die Grenzen des Dynamikbereichs gewählt werden, der den Kontrast bestimmt; und
- Fig. 9: ein weiteres Flussdiagramm eines Ausführungsbeispiels des erfindungsgemäßen Verfahrens, das beschreibt, wie die Grenzen des Dynamikbereichs gewählt werden, welcher den Kontrast bestimmt.

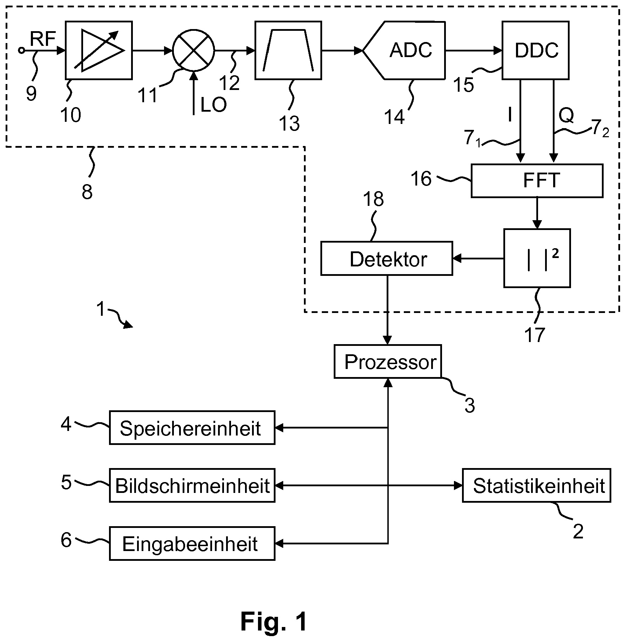

Fig. 1 zeigt ein Ausführungsbeispiel eines Blockschaltbilds, das den Aufbau der erfindungsgemäßen Messvorrichtung 1 näher beschreibt. Die Messvorrichtung 1 zur Erhöhung eines Kontrasts einer Vielzahl in einem Spektrogramm oder spektralen Histogramm dargestellten Messwerte eines zu analysierenden Messsignals 7₁, 7₂ umfasst dabei zumindest eine zentrale Datenverarbeitungseinheit 3, die auch als Recheneinheit 3 bezeichnet wird. Die zentrale Datenverarbeitungseinheit 3 kann einen oder mehrere Prozessoren und/oder FPGAs (engl. Field Programmable Gate Array; dt. im (Anwendungs-)Feld programmierbare (Logik-) Gatter-Anordnung) und/oder DSP (engl. digital signal processor; dt. digitaler Signalprozessor) aufweisen. Mit der zentralen Datenverarbeitungseinheit 3 sind zumindest eine Statistikeinheit 2, eine Speichereinheit 4, eine Bildschirmeinheit 5, eine Eingabeeinheit 6 und eine Erfassungseinheit 18 verbunden. Unter einem spektralen Histogramm wird ein "nachleuchtendes" (engl. persistence) Histogramm verstanden, bei welchem aufeinander folgende Spektren übereinander gezeichnet, bzw. gemalt werden und farblich mit der Auftrittshäufigkeit codiert werden.

Bei der zumindest einen Speichereinheit 4 kann es sich beispielsweise um einen Arbeitsspeicher und/oder einen Festplattenspeicher handeln, der innerhalb der Messvorrichtung 1 ausgebildet ist und/oder mit der Messvorrichtung 1 über beispielsweise eine Netzwerkschnittstelle verbunden ist.

Die mit der zentralen Datenverarbeitungeinheit 3 verbundene Erfassungseinheit 18 empfängt, wie später noch ausführlich erläutert wird, eine Vielzahl von Messwerten, die einen bestimmten Pegelwert aufweisen und ein zu analysierendes Messsignal 7₁, 7₂ für eine bestimmte Frequenz zu einem bestimmten Zeitpunkt abbilden. Bei dem zu analysierenden Messsignal 7₁, 7₂ kann es sich um jedwedes Kommunikationssignal, wie zum Beispiel um ein GSM-Signal handeln.

In Fig. 1 ist hierzu ein vereinfachtes Blockschaltbild eines Signalanalysators 8 dargestellt. Ein zu analysierendes hochfrequentes Messsignal 9, beispielsweise ein GSM-Signal, wird durch einen Verstärker 10 in seiner Amplitude verstärkt. Anschließend wird das verstärkte hochfrequente Messsignal 9 über einen Mischer 11 mittels eines lokalen Oszillatorsignals auf eine Zwischenfrequenz 12 heruntergemischt. Das auf eine Zwischenfrequenz 12 heruntergemischte hochfrequente Messsignal 9 wird anschließend durch einen Bandpass 13 gefiltert, bevor es durch einen Analog-/Digitalumsetzer 14 digitalisiert wird. Über einen digitalen Abwärtswandler 15 (engl. digital down converter) wird das digitalisierte Hochfrequenzsignal in das Basisband heruntergemischt. Bei dem in das Basisband heruntergemischten Messsignal handelt es sich um das zu analysierende Messsignal 7₁, 7₂, von dem die Inphase- (dt. gleichphasig) und die Quadraturphase-Komponente vorliegt. Für den Fall, dass es sich bei dem hochfrequenten Messsignal 9 um ein Messsignal 9 handelt, welches beispielsweise von einer Basisstation (z.B. GSM) ausgesendet wird, wird statt eines Verstärkers 10 ein Dämpfungsglied oder ein Koppler verwendet, an dessen Ausgang ein Signal mit einer wesentlich kleineren Amplitude anliegt.

Das Messsignal 7₁, 7₂ wird im Weiteren einer Fourier-Transformationseinheit 16 zugeführt, die dieses z.B. mittels einer schnellen Fourier-Transformation in den Frequenzbereich transformiert. Bevorzugt werden eine Vielzahl von parallel arbeitenden schnellen Fourier-Transformationseinheiten verwendet, deren berechnetes Frequenzspektrum sich gegenseitig überlagern kann.

Das Ergebnis der Fourier-Transformationseinheit 16 wird einer Betragseinheit 17 zugeführt, die aus den komplexen Spannungswerten der Fourier-Transformationseinheit 16 eine Leistung berechnet.

Das Ergebnis der Betragseinheit 17 wird der Erfassungseinheit 18 zugeführt. Die Erfassungseinheit 18 beinhaltet dabei eine Detektoreinheit, die eine Vielzahl von Messwerten mittelt, oder aus einer Vielzahl von Messwerten den Maximalwert oder den Minimalwert auswählt und diesen an die zentrale Datenverarbeitungseinheit 3 übermittelt, wobei die Vielzahl einstellbar ist.

Die mit der zentralen Datenverarbeitungseinheit 3 verbundene Statistikeinheit 2, die auch direkt in der zentralen Datenverarbeitungseinheit 3 ausgebildet sein kann, berechnet eine Auftritts-Häufigkeit für jeden Pegelwert der dazustellenden Messwerte. Es ist dabei zu beachten, dass die Erfassungseinheit 18 bevorzugt nur so viele Messwerte von einem bestimmten Zeitpunkt an die zentrale Datenverarbeitungseinheit 3 übergibt, wie die Bildschirmeinheit 5 im Spektrogramm, bevorzugt auf der horizontalen Achse, anzeigen kann. Es ist allerdings auch möglich, dass die Erfassungseinheit 18 für einen diskreten Zeitpunkt mehr Messwerte an die zentrale Datenverarbeitungseinheit 3 übergibt, als die Bildschirmeinheit 5 anzeigen kann. Dies erlaubt der Statistikeinheit 2 eine genauere Berechnung der Verteilung Auftritts-Häufigkeit.

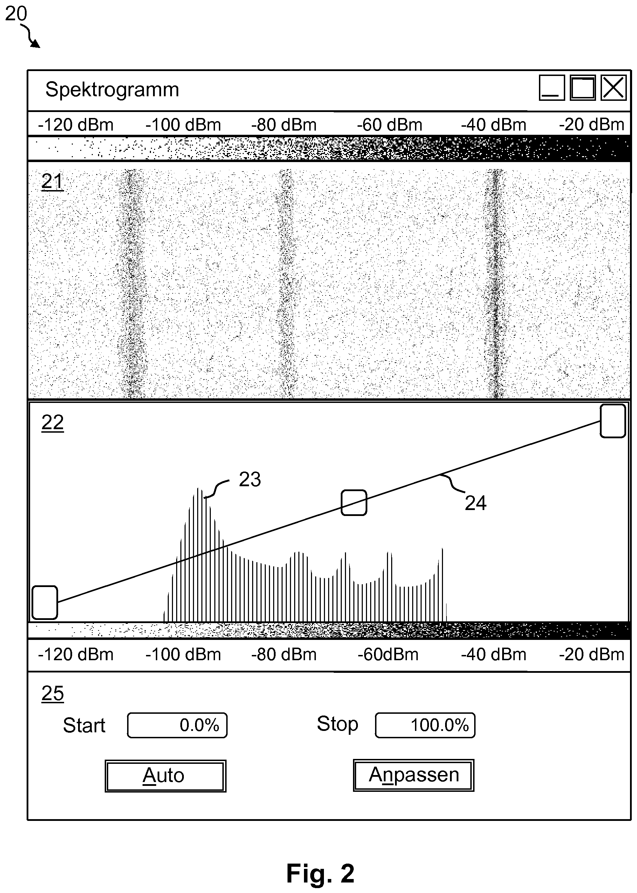

Fig. 2 zeigt ein Ausführungsbeispiel, welches erläutert, wie die erfindungsgemäße Messvorrichtung 1 den Kontrast der anzuzeigenden Messwerte erhöht. Dargestellt ist in Fig. 2 ein Bildschirmausschnitt 20, welcher beispielsweise auf der Bildschirmeinheit 5 dargestellt werden kann. Der Bildschirmausschnitt 20 gliedert sich in drei Bereiche. Ein erster Bereich zeigt ein Spektrogramm 21, in welchem die darzustellenden Messwerte über die Frequenz und die Zeit aufgetragen sind. Neue Messwerte werden bevorzugt in der obersten Zeile eingefügt. Die älteren Messwerte werden daraufhin jeweils eine Zelle nach unten geschoben. Daher wird bei dem Spektrogramm 21 auch von einem Wasserfalldiagramm gesprochen. Messwerte, die einen hohen Signalpegel aufweisen, werden in der Darstellung aus Fig. 2 dunkler dargestellt, wohingegen Messwerte mit einem niedrigen Signalpegel heller dargestellt werden.

Zu erkennen ist, dass das Spektrogramm 21 Messwerte anzeigt, deren Signalpegel sich stark unterscheiden. Die Skalierung reicht hierbei von Signalpegeln, die eine Leistung von -20 dBm aufweisen, bis hin zu Signalpegeln, die eine Leistung von -120 dBm aufweisen. Aufgrund der Tatsache, dass hier ein sehr weiter Leistungsbereich dargestellt wird, ist der Kontrast, das eigentliche Nutzsignal betreffend, relativ gering. Unterschiedliche Pegelwerte werden, wie in Fig. 2 gezeigt, durch unterschiedliche Helligkeitsabstufungen dargestellt. Es ist allerdings auch möglich, dass diese durch unterschiedliche Farben oder durch unterschiedliche Graustufen darstellbar sind. Bevorzugt werden für unterschiedliche Pegelwerte unterschiedliche Farben verwendet.

Ein zweiter Bereich in dem Bildschirmausschnitt 20 aus Fig. 2 zeigt ein Diagramm 22, in welchem eine Verteilung 23 der einzelnen Messwerte nach deren Auftritts-Häufigkeit für die entsprechenden Pegelwerte dargestellt ist. Dabei wird auf der horizontalen Achse der Pegelwert, also die Leistung des aufgenommenen Messwerts dargestellt. Die horizontale Achse ist dabei von -20 dBm bis -120 dBm skaliert. Auf der vertikalen Achse ist die Auftritts-Häufigkeit für jeden Pegelwert dargestellt. Die Auftritts-Häufigkeit kann dabei z.B. auf 100 % bezogen sein oder auch einer frei wählbaren Normierung unterliegen.

Gut zu erkennen ist, dass die Verteilung 23 ein Maximum aufweist für Pegelwerte zwischen -90 dBm und -100 dBm. Weiterhin ist noch zu erkennen, dass die aufgenommenen Messwerte allesamt einen Pegelwert aufweisen, der zwischen -40 dBm und -100 dBm liegt, wohingegen die Skalierung von -20 dBm bis hin zu -120 dBm reicht. Die aufgenommenen Messwerte, die in dem Diagramm 22 innerhalb der Verteilung 23 dargestellt sind, sind ebenfalls in dem Spektrogramm 21 dargestellt. Alle neuen Messwerte, die von der Erfassungseinheit 18 gemäß dem Ausführungsbeispiel aus Fig. 1 erfasst werden, werden wie bereits beschrieben, bevorzugt in der obersten Zeile des Spektrogramms 21 eingefügt. Sowohl das Spektrogramm 21, als auch das Diagramm 22, welches die Verteilung 23 beinhaltet, werden für jeden neu aufgenommenen Messwert aktualisiert.

Aufgrund der Tatsache, dass die Fourier-Transformationseinheit 16 beispielsweise 250.000 schnelle Fourier-Transformationen pro Sekunde berechnet und auf einer horizontalen Zeile im Spektrogramm 21 beispielsweise 1.024 Messwerte angezeigt werden können, unter der Annahme dass die Bildschirmeinheit 5 beispielsweise 30 Vollbilder pro Sekunde anzeigen kann, müssen acht oder neun gemessene Messwerte innerhalb der Erfassungseinheit 18 zu einem aufgenommenen Messwert gemittelt werden oder aus acht oder neun gemessenen Messwerten einer ausgewählt werden (max, min) .

Wie bereits erläutert, erstreckt sich der Kontrast über Pegelwerte von mehr als -20 dBm bis hin zu -120 dBm, wobei die aufgenommenen Messwerte gemäß der Verteilung 23 sich zwischen weniger als -40 dBm und weniger als -100 dBm erstrecken, wodurch das eigentliche Signal im Spektrogramm 21 kontrastarm dargestellt ist. Der Bereich, über den sich der Kontrast erstreckt, wird, wie in dem Diagramm 22 gezeigt, über einen Dynamikbereich 24 festgelegt. Der Dynamikbereich 24 ist in dem Ausführungsbeispiel aus Fig. 2 durch eine schräge Linie dargestellt, an deren Ende und/oder an deren Mitte sich Rechtecke befinden. Für den Fall, dass es sich bei der Bildschirmeinheit 5 um einen Berührungsbildschirm handelt, kann ein Benutzer durch Antippen dieser Rechtecke diese verschieben, wodurch die Länge der Linie verändert wird und wodurch der Dynamikbereich 24 eingeschränkt wird. Wie später noch ausführlich gezeigt wird, legt der Dynamikbereich 24 den Kontrast fest, sodass bei Veränderung des Dynamikbereichs 24 der Kontrast für das eigentliche Nutzsignal 7₁, 7₂ erhöht oder verringert werden kann.

Weiterhin ist in dem Bildschirmausschnitt 20 noch ein dritter Bereich 25 ausgebildet. In diesem dritten Bereich 25 kann ein Benutzer den Start und das Ende des Dynamikbereichs 24 zum Beispiel mittels einer Tastatur eingeben. Wie bereits beschrieben, ist der Dynamikbereich 24 in dem Diagramm 22 nicht beschränkt, sodass für den Startwert 0 % und für den Stoppwert 100 % angezeigt wird. Über die Schaltflächen "Auto" und "Anpassen" wird der Dynamikbereich 24, wie später noch ausführlich erläutert wird, von der erfindungsgemäßen Messvorrichtung 1 automatisch an die Verteilung 23 bzw. automatisch an das eigentliche Nutzsignal 7₁, 7₂ angepasst. Ein Klick auf die Schaltfläche "Auto" sorgt dafür, dass der Dynamikbereich 24 an die Verteilung 23 angepasst wird. Ein Klick auf die Schaltfläche "Anpassen" sorgt dafür, dass der Dynamikbereich 24 auf das eigentliche Nutzsignal 7₁, 7₂ angepasst wird und zumindest ein festgelegter Anteil derjenigen Pegelwerte, die das Rauschen abbilden, eben nicht zur Festlegung des Dynamikbereichs 24 verwendet wird.

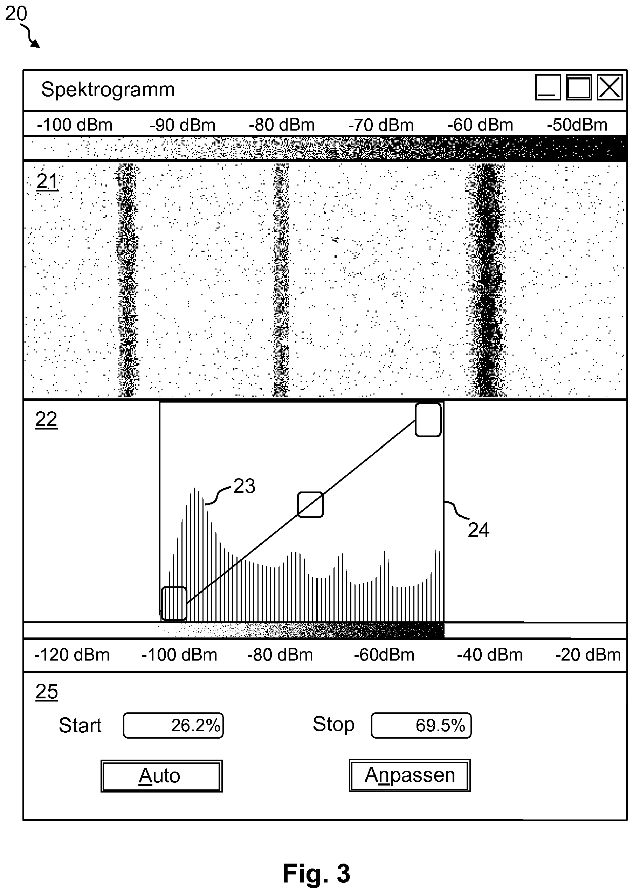

Fig. 3 zeigt ein Spektrogramm 21, in welchem die erfassten Messwerte mit einem höheren Kontrast angezeigt sind und ein Diagramm 22, in dem eine Verteilung 23, die die Auftritts-Häufigkeit der einzelnen Pegelwerte angibt angezeigt ist, wobei ein Dynamikbereich 24, über den sich der Kontrast erstreckt, auf die Verteilung 23 festgelegt ist.

Gut zu erkennen ist, dass in Fig. 3 im Gegensatz zu Fig. 2 sich der Kontrast nicht mehr von -20 dBm bis hin zu -120 dBm erstreckt, sondern dieser auf -50 dBm bis hin zu -100 dBm eingeschränkt ist. Pegelwerte, die nicht von dem Dynamikbereich 24 erfasst werden und kleiner oder größer als der vom Dynamikbereich 24 eingeschlossene Pegelwertbereich sind, werden in dem Ausführungsbeispiel aus Fig. 3 in einem einheitlichen Farbton, z.B. in Weiß dargestellt. Tatsächlich sollten allerdings Pegelwerte, die kleiner als der vom Dynamikbereich 24 eingeschlossene Pegelwertbereich sind unterschiedlich, also mit einer anderen Farbe und/oder mit einer anderen Helligkeit dargestellt werden, als diejenigen Pegelwerte, die größer sind, als der vom Dynamikbereich 24 eingeschlossene Pegelwertbereich. Diese Farben sollten bevorzugt nicht in dem Farbraum enthalten sein, der zur Darstellung der Pegelwerte verwendet wird, die innerhalb des Dynamikbereichs 24 liegen. Sollten unterschiedliche Pegelwerte durch unterschiedliche Farben repräsentiert werden, so werden diejenigen Pegelwerte, die nicht von dem Dynamikbereich 24 eingeschlossen sind und kleiner als dieser sind, bevorzugt in einer sehr dunklen Farbe, insbesondere in schwarz oder dunkelblau, dargestellt. Diejenigen Pegelwerte am oberen Ende des Dynamikbereichs 24, also diejenigen Pegelwerte mit einer hohen Leistung, würden in diesem Fall mit einer sehr hellen Farbe, wie z.B. weiß, dargestellt werden. Die Skalierung der horizontalen Achse im Spektrogramm 21 entspricht stets dem geänderten Dynamikbereich 24 bzgl. seiner Abmessung auf der horizontalen Achse im Diagramm 22, auf der die verschiedenen Pegelwerte aufgetragen sind.

Wie bereits erläutert, wird der Dynamikbereich 24 automatisch an die Verteilung 23 angepasst, sobald ein Benutzer auf die Schaltfläche "Auto" klickt. In diesem Fall ist die Recheneinheit 3, also die zentrale Datenverarbeitungseinheit 3, ausgebildet, um einzig Pegelwerte beim Festlegen des Dynamikbereichs 24 zu berücksichtigen, deren Auftritts-Häufigkeit und/oder deren Pegelwert über einen einstellbaren Schwellwert liegen. Dies bedeutet, dass z.B. ein Messwert, dessen Pegelwert bei z.B. -120 dBm liegt und/oder dass ein weiterer Messwert, dessen Pegelwert bei z.B. -20 dBm liegt, nicht zwingend zur Festlegung des Dynamikbereichs 24 verwendet werden. Für den Fall, dass diese Messwerte nur mit einer sehr geringen Auftritts-Häufigkeit erscheinen, werden diese nicht zur Festlegung des Dynamikbereichs 24 verwendet. Diese Auftritts-Häufigkeit kann z.B. in absoluten Werten, bezogen auf die Anzahl der im Spektrogramm 21 dargestellten Messwerte angegeben werden.

Wie bereits erläutert, kann auch eingestellt sein, dass Pegelwerte, die größer sind als z.B. -30 dBm und kleiner sind als z.B. -110 dBm nicht zur Festlegung des Dynamikbereichs 24 verwendet werden. Die Recheneinheit 3, also die zentrale Datenverarbeitungseinheit 3, aktualisiert den Dynamikbereich 24 fortlaufend, also maximal mit jedem neuen Messwert, der von der Erfassungseinheit 18 an die zentrale Datenverarbeitungseinheit 3 übergeben wird. Bevorzugt wird der Dynamikbereich 24 allerdings nur so oft neu berechnet, wie es der Bildschirmeinheit 5 möglich ist, ein geändertes Spektrogramm 21 anzuzeigen. Es ist daher in diesem Beispiel ausreichend, dass die zentrale Datenverarbeitungseinheit 3, also die Recheneinheit 3, den Dynamikbereich 24 30 Mal pro Sekunde anpasst. Zu erkennen ist, dass sich im Spektrogramm 21 der Kontrast deutlich erhöht hat und das eigentliche Nutzsignal 7₁, 7₂, welches durch die Vielzahl der erfassten Messwerte dargestellt wird, deutlich hervorgehoben ist. Ebenfalls gut zu erkennen ist, dass sich die Skalierung der vertikalen Achse, die den Pegelwert, also die Leistung der darzustellenden Messwerte beschreibt, geändert hat.

In dem dritten Bereich 25, in welchem der Startwert und der Endwert für den Dynamikbereich 24 angezeigt wird, sind die Änderungen für den Dynamikbereich 24 erfasst. Der Startwert beträgt im Folgenden beispielsweise 26,2 % und der Endwert 69,5 %.

Gut zu erkennen ist allerdings dennoch, dass ein signifikanter Anteil derjenigen Pegelwerte, die das Rauschen abbilden, dennoch zur Festlegung des Dynamikbereichs 24 verwendet werden. Im Folgenden wird daher detailliert beschrieben, wie mittels der erfindungsgemäßen Messvorrichtung 1 auch die oben genannten Pegelwerte für die Berechnung des Dynamikbereichs 24 nicht mehr berücksichtigt werden.

Gut zu erkennen ist, dass der Dynamikbereich 24 nicht die gesamte Verteilung 23 innerhalb des Diagramms 22 umfasst. Die "Rauschbeulen" am unteren Ende der Verteilung 23 wird durch den Dynamikbereich 24 ausgeblendet. Gut zu erkennen ist, dass der Kontrast, wie bereits beschrieben, einzig durch den Dynamikbereich 24 festgelegt wird und dass sich dieser Kontrast nunmehr von ca. -50 dBm bis hin zu -90 dBm erstreckt. Die Skalierung der vertikalen Achse innerhalb des Spektrogramms 21 ist entsprechend dem neuen Dynamikbereich 24 geändert. Gut zu erkennen ist, dass das eigentliche Nutzsignal 7₁, 7₂, welches durch die aufgenommenen Messwerte repräsentiert wird, sehr scharf in dem Spektrogramm 21 zu erkennen ist und mit einem sehr hohen Kontrast dargestellt ist.

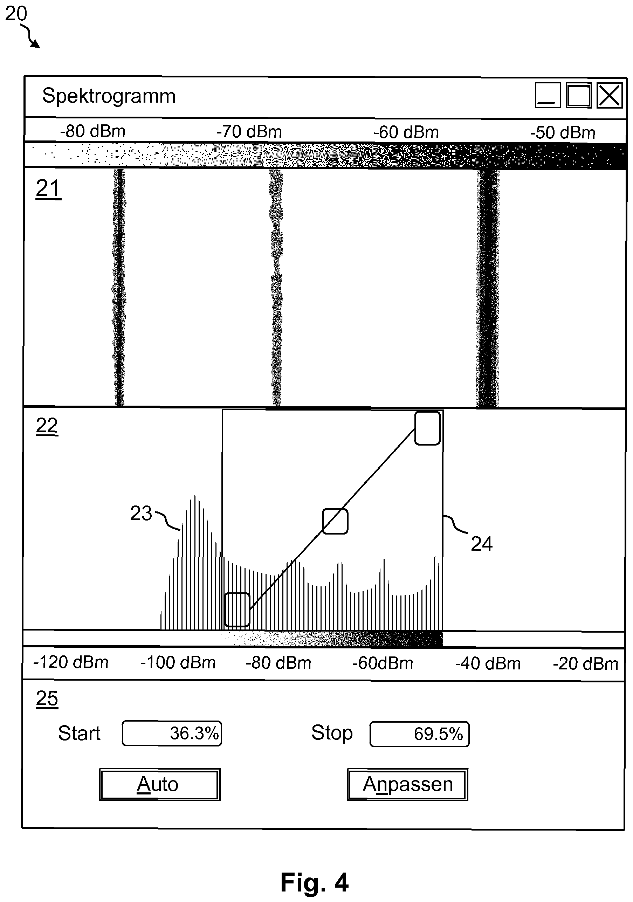

Im dritten Bereich 25 hat sich der Startwert, also der Wert für das untere Ende des Dynamikbereichs 24 von 26,2 % auf 36,3 % erhöht. Die Änderung des Dynamikbereichs 24 ist dadurch erfolgt, dass der Benutzer beispielsweise auf die Schaltfläche "Anpassen" geklickt hat. Im Folgenden werden drei Möglichkeiten beschrieben, die auch miteinander kombiniert werden können und die es erlauben, von dem in Fig. 3 eingestellten Dynamikbereich 24 auf den in Fig. 4 gezeigten eingeschränkten Dynamikbereich 24 zu gelangen.

Bei der ersten Möglichkeit, ist die Statistikeinheit 2 ausgebildet, um einen ersten Pegelwert zu ermitteln, dessen Auftritts-Häufigkeit am höchsten ist und der in einer einstellbaren Leistungsbandbreite, z.B. zwischen - 110 dBm und -80 dBm liegt, wobei diese einstellbare Leistungsbandbreite derart gewählt werden muss, dass das Geräterauschen nicht in diesem liegt. Die Werte zum Einstellen der Leistungsbandbreite werden vorzugsweise aus der Speichereinheit 4 entnommen. Dadurch wird sichergestellt, dass z.B. für den Fall, dass es sich bei dem eigentlichen Messsignal 7₁, 7₂ z.B. um ein Sinussignal handelt, dessen Auftritts-Häufigkeit über dem Rauschen liegt, der Dynamikbereich 24 dennoch ausgehend von dem Maximum des Rauschens (lokales Maximum) und nicht von dem gesamten Maximum der Auftritts-Häufigkeit eingestellt wird. Die Recheneinheit 3, also die zentrale Datenverarbeitungseinheit 3, ist ausgebildet, um eine untere Grenze für den Dynamikbereich 24 festzulegen, die diesem ersten Pegelwert entspricht. Mit der Annahme, dass der Pegelwert, dessen Auftritts-Häufigkeit in einer bestimmten Leistungsbandbreite am höchsten ist, stets diejenigen Messwerte beinhaltet, die das Rauschen abbilden, kann ein ausreichend hoher Kontrast erzielt werden. Es ist allerdings auch möglich, dass die Statistikeinheit 2 den Verlauf der Verteilung 23 interpoliert und den ersten Wendepunkt innerhalb des Verlaufs der Verteilung 23, beginnend vom unteren Ende des Dynamikbereichs 24, also von dem Ende mit den niedrigsten Pegelwerten, als den Pegelwert festlegt, dessen Auftritts-Häufigkeit am höchsten ist. In diesem Fall kann die "Rauschbeule" sicher erkannt werden.

Weiterhin kann die Recheneinheit 3, also die zentrale Datenverarbeitungseinheit 3, auch ausgebildet sein, um eine untere Grenze für den Dynamikbereich 24 derart festzulegen, dass diese einem zweiten Pegelwert entspricht, wobei der zweite Pegelwert größer ist, als der erste Pegelwert und wobei ein Abstand zwischen dem ersten Pegelwert und dem zweiten Pegelwert einstellbar ist. Der Abstand zwischen dem ersten Pegelwert und dem zweiten Pegelwert kann beispielsweise von der Recheneinheit 3, also der zentralen Datenverarbeitungseinheit 3, aus der zumindest einen Speichereinheit 4 geladen werden. Der Abstand kann beispielsweise auf Erfahrungswerten beruhen, die angeben, dass auf das Maximum der "Rauschbeule" innerhalb der z.B. nächsten 10 dB mit keinem Nutzsignal 7₁, 7₂ zu rechnen ist. Dieser Sachverhalt kann beispielsweise dem eingestellten Dynamikbereich 24, wie er in Fig. 4 dargestellt ist, zugrunde liegen.

Schließlich kann die Recheneinheit 3, also die zentrale Datenverarbeitungseinheit 3 auch so ausgebildet sein, dass eine untere Grenze für den Dynamikbereich 24 derart festgelegt wird, dass diese oberhalb eines niedrigsten Pegelwerts liegt und von diesem durch einen einstellbaren Abstand beabstandet ist. Bei einem niedrigsten Pegelwert handelt es sich bevorzugt um einen Pegelwert, der einen bestimmten Stellwert bezüglich seiner Auftritts-Häufigkeit überschritten hat, wobei es keinen weiteren Pegelwert gibt, der ebenfalls einen einstellbaren Schwellwert für die Auftritts-Häufigkeit überschritten hat und einen niedrigeren Pegelwert aufweist. Ausgehend von diesem niedrigsten Pegelwert innerhalb der Verteilung 23 kann die untere Grenze für den Dynamikbereich 24 durch einen einstellbaren Abstand beabstandet sein. Es ist in diesem Fall möglich, dass die untere Grenze für den Dynamikbereich 24 einen niedrigeren Pegelwert aufweist, als der Pegelwert, dessen Auftritts-Häufigkeit am höchsten ist. Die untere Grenze des Dynamikbereichs 24 würde in dem Diagramm 22 aus Fig. 4 folglich links von dem Maximum der Verteilung 23 liegen. Es ist allerdings auch möglich, dass dieser Abstand derart groß gewählt wird, dass die untere Grenze des Dynamikbereichs 24 dennoch rechts von dem Maximum der Auftritts-Häufigkeit der Verteilung 23 liegt.

Eine zweite Möglichkeit zur Festlegung des Dynamikbereichs 24 erfolgt, indem die Recheneinheit 3, also die zentrale Datenverarbeitungseinheit 3, derart ausgebildet ist, dass sie die berechnete Verteilung 23 mit zumindest zwei gespeicherten Verteilungen korreliert und dass die Recheneinheit 3 ausgebildet ist, um den Dynamikbereich 24, über den sich der Kontrast erstreckt, gemäß einem gespeicherten Dynamikbereich festzulegen, wobei der gespeicherte Dynamikbereich mit der gespeicherten Verteilung verknüpft ist, für die das Ergebnis der Korrelation den höchsten Wert aufweist. Häufig ist es dabei so, dass die in dem Diagramm 22 dargestellte Verteilung, die ein Nutzsignal 7₁, 7₂ eines bestimmten Typs, wie z.B. GSM oder UMTS, repräsentiert, eine Ähnlichkeit zu einer gespeicherten Verteilung aufweist, die für den gleichen Signaltyp aufgenommen worden ist.

Dies hängt auch damit zusammen, dass die Verteilung 23 eine Vielzahl von Messwerten beinhaltet, die über einen längeren Zeitraum aufgenommen worden sind. Für jede dieser gespeicherten Verteilungen ist ein Dynamikbereich gespeichert und diesem zugewiesen. Dieser gespeicherte Dynamikbereich kann beispielsweise nach der beschriebenen ersten Möglichkeit ermittelt worden sein oder auch zu einem früheren Zeitpunkt von einem Benutzer von Hand eingestellt worden sind. Die gespeicherten Verteilungen 23 unterscheiden sich beispielsweise in ihrer Lage bezüglich den Pegelwerten und/oder in der Auftritts-Häufigkeit der einzelnen Pegelwerte. Für den Fall, dass eine gespeicherte Verteilung ein Nutzsignal des gleichen Typs beinhaltet, wie das zu messende Nutzsignal 7₁, 7₂ kann zwar die Form der gespeicherten Verteilung variieren, allerdings wird dabei dennoch der Kontrast deutlich besser eingestellt, als wenn der Dynamikbereich 24 die gesamte Verteilung 23 umfassen würde. Bei der Korrelation sollte allerdings die Lage der Verteilung nicht mitberücksichtigt werden. Denn auch eine gespeicherte Verteilung, die ein leistungsstarkes Nutzsignal repräsentiert, kann zur Bestimmung der "Rauschbeule" eines leistungsschwachen Nutzsignals 7₁, 7₂ verwendet werden, um den Kontrast dennoch gut zu erhöhen.

Weiterhin gibt es noch eine dritte Möglichkeit, um den Dynamikbereich 24 einzustellen. Wie bereits erläutert dienen die Vielzahl der in dem Spektrogramm 21 dargestellten Messwerte dazu, zumindest ein zu analysierendes Signal 7₁, 7₂ abzubilden. Die Recheneinheit 3, also die zentrale Datenverarbeitungseinheit 3, ist dabei ausgebildet, um den Dynamikbereich 24, über den sich der Kontrast erstreckt, derart festzulegen, dass dieser einen gespeicherten Dynamikbereich entspricht, wobei der gespeicherte Dynamikbereich für ein Signal hinterlegt ist, das die gleiche Modulationsart und/oder die gleiche Frequenz und/oder die gleiche Bandbreite aufweist, wie das zu analysierende Signal 7₁, 7₂.

Wie bereits erläutert, können in der zumindest einen Speichereinheit 4 eine Vielzahl von Signalen hinterlegt, bzw. gespeichert sein, die mit ebenfalls einem Dynamikbereich verknüpft sind, sodass bei Kenntnis von verschiedenen Parametern des zu messenden Signals 7₁, 7₂ ein Dynamikbereich 24 derart eingestellt werden kann, dass diejenigen Messwerte, die das Rauschen abbilden, nicht zur Festlegung dieses Dynamikbereichs 24 verwendet werden. Häufig ist es dabei so, dass ein Benutzer ein bekanntes Signal, z.B. ein GSM-Signal analysieren möchte, von dem er beispielsweise schon die Modulationsart sowie die Bandbreite und die Frequenz kennt. In diesem Fall kann aus der zumindest einen Speichereinheit 4 ein Dynamikbereich geladen werden, der für ein Signal des gleichen Typs bereits hinterlegt ist. Dieser Dynamikbereich dient dann zur Einstellung des Dynamikbereichs 24.

Bevorzugt ist sowohl bei der zweiten Möglichkeit, als auch bei der dritten Möglichkeit der gespeicherte Dynamikbereich in Bezug zur Lage der gespeicherten Verteilung und/oder des gespeicherten Signals gespeichert. Es ist daher klar, dass die untere Grenze des gespeicherten Dynamikbereichs z.B. 20 dB über dem niedrigsten Pegelwert liegt, dessen Auftritts-Häufigkeit einen Schwellwert überschreitet und zur Bildung der Verteilung 23 beiträgt. Dies erlaubt, dass der Dynamikbereich 24 der gemessenen Verteilung 23 entsprechend angepasst werden kann, unabhängig von der tatsächlichen Lage der Verteilung 23.

Wie bereits erläutert, kann der Dynamikbereich 24 auch direkt von einem Benutzer eingestellt werden. Bevorzugt geschieht dies durch das Antippen und Verschieben der Rechtecke bei Verwendung einer berührungsempfindlichen Bildschirmeinheit 5. Wie bereits erläutert, gibt es noch ein Rechteck 40, welches bevorzugt in der Mitte des Dynamikbereichs 24 ausgebildet ist. Durch Verschieben dieses Rechtecks, sowohl in seiner vertikalen, als auch in seiner horizontalen Position kann die Linie, die beiden äußeren Rechtecke miteinander verbindet, gekrümmt werden. Dies erlaubt, dass der Farbverlauf oder der Graustufenverlauf oder den Helligkeitsabstufungsverlauf innerhalb des Dynamikbereichs 24 von einem linearen auf einen parabelförmigen oder einen exponentiellen oder einen sonstigen nicht-linearen Verlauf geändert wird. Dadurch können Messwerte, die einen bestimmten Pegelwert aufweisen, nur sehr schwach dargestellt werden, wohingegen andere Messwerte, die beispielsweise einen höheren Pegelwert aufweisen, deutlich verstärkt dargestellt werden. Es ist auch möglich, dass noch eine gewisse "Reserve" vorgehalten wird, sodass für den Fall, dass ein sehr hoher Pegelwert gemessen wird, dieser dennoch dargestellt werden kann. Würde in dem Ausführungsbeispiel aus Fig. 4 z.B. noch ein Pegelwert mit einer Leistung von z.B. -20 dBm erfasst werden, so könnte bei Vorhalten einer bestimmten "Reserve" des Kontrasts dieser auch sicher dargestellt werden. Die Farbhelligkeit kann daher auch moduliert werden.

Es ist auch möglich, dass die Pegelwerte der gemessenen Messwerte in einer kumulierten Verteilung (z.B. CDF (engl. cumulative distribution function) oder CCDF (engl. complementary cumulative distribution function; dt. komplementäre kumulierte Verteilungsfunktion)) aufgetragen werden. In diesem Fall kann z.B. sehr einfach angegeben werden, dass Pegelwerte bis zu einer bestimmten Schwelle, die einstellbar ist, oder die aus der zumindest einen Speichereinheit 4 geladen werden kann, für die Einstellung des Kontrasts nicht berücksichtigt werden. Es kann auch sein, dass eine solche kumulierte Verteilung für jede gespeicherte Verteilung und/oder für jedes gespeicherte Signal hinterlegt ist, sodass für das entsprechende Korrelationsergebnis der entsprechende Schwellwert der hinterlegten kumulierten Verteilung geladen wird. Selbiges gilt auch für die hinterlegte kumulierte Verteilung desjenigen Signals, welches von den Signaleigenschaften, wie z.B. Modulationsart und/oder Frequenz und/oder Bandbreite am ähnlichsten zu dem gemessenen Signal ist.

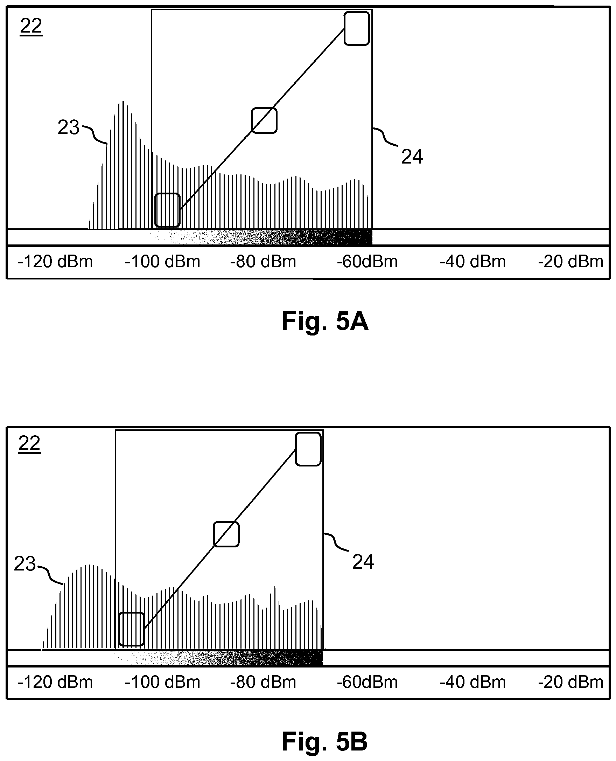

Fig. 5A zeigt eine Verteilung 23, die die Auftritts-Häufigkeit der einzelnen Pegelwerte der darzustellenden Messwerte angibt, und einen Dynamikbereich 24, über den sich der Kontrast erstreckt und der das Rauschen ausschließt. Im Unterschied zu dem Diagramm 22 aus Fig. 4 ist in dem Diagramm 22 aus Fig. 5A die Verteilung 23 hin zu niedrigeren Pegelwerten verschoben. Der Dynamikbereich 24 schließt aber nach wie vor die "Rauschbeule" der Verteilung 23 nach einer oder mehreren der zuvor genannten Möglichkeiten aus. Eine solche Verschiebung der Verteilung 23 kann beispielsweise dadurch erfolgen, dass die Auflösebandbreite der Fourier-Transformationseinheit 16 verkleinert worden ist. Eine solche Verschiebung der Verteilung 23 kann auch dann stattfinden, wenn die Messzeit verändert wird, also weniger Messwerte miteinander gemittelt werden. Allerdings orientiert sich der einmal ermittelte Dynamikbereich 24 nicht an absoluten Pegelwerten, sondern bevorzugt an der darzustellenden Verteilung 23. Dieser Dynamikbereich 24 ist beispielsweise derart eingestellt, dass seine untere Grenze z.B. 15 dB über dem niedrigsten Pegelwert der Verteilung 23 liegt. In diesem Fall verschiebt sich der Dynamikbereich 24 zusammen mit der Verteilung 23 bei Änderung der Bandbreite der Fourier-Transformationseinheit 16, allerdings bleibt die untere Grenze des Dynamikbereichs 24 weiterhin z.B. 15 dB über dem niedrigsten neuen Pegelwert der Verteilung 23.

Fig. 5B zeigt eine weitere Verteilung 23, die die Auftritts-Häufigkeit der einzelnen Pegelwerte der darzustellenden Messwerte angibt und einen Dynamikbereich 24 beinhaltet, der den Kontrast derart festlegt, dass das Rauschen ausgeschlossen ist. Wie bereits erläutert, kann sich die Lage der Verteilung 23 verschieben, je nachdem wie hoch die Bandbreite der Fourier-Transformationseinheit 16 gewählt ist, oder je nachdem, wie groß die Messzeit gewählt ist. Dabei kann sich auch die Form der Verteilung 23 verändern. Der Dynamikbereich 24 passt sich allerdings sowohl der neuen Lage der Verteilung 23 als auch der neuen Form der Verteilung 23 an. Für den Fall, dass sich die Verteilung 23 vor Änderung der Messparameter über einen Bereich von z.B. 50 dB erstreckt und für den Fall, dass sich diese nach Änderung der Messparameter nur noch über einen Bereich von z.B. 40 dB erstreckt, wird der Bereich, über den sich der Dynamikbereich 24 erstreckt, entsprechend angepasst, in diesem Fall gestaucht. In anderen Fällen kann der Dynamikbereich 24 auch gestreckt werden. Es ist auch möglich, dass bei einer Änderung der Messparameter der Dynamikbereich 24 wieder von Neuem festgelegt wird. Hierzu stehen die bereits erläuterten drei Möglichkeiten zur Verfügung.

Selbiges gilt auch, wenn der Benutzer die Zoomfunktion einsetzt, um bestimmte Bereiche innerhalb des zu analysierenden Messsignals 7₁, 7₂ genauer zu analysieren. Eine manuelle Nachjustierung des Kontrasts bzw. eine manuelle Nachjustierung der Farben soll möglichst nicht stattfinden.

Es ist auch möglich, dass in dem Spektrogramm 21 ein bestimmter Frequenzbereich ausgewählt wird, wobei die Pegelwerte derjenigen Messwerte, die sich innerhalb des Frequenzbereichs befinden, zur Festlegung des Kontrasts herangezogen werden. Auch in diesem Fall kann die "Rauschbeule" ausgeblendet werden, d.h. der Dynamikbereich 24, der den Kontrast festlegt, bezieht diejenigen Messwerte innerhalb des ausgewählten Frequenzbereichs nicht mit ein, die das Rauschen abbilden. Die übrigen Messwerte außerhalb des ausgewählten Frequenzbereichs werden dann in einer einheitlichen Farbe, z.B. in schwarz oder in weiß dargestellt, und damit einheitlich dargestellt. Statt einem Frequenzbereich können auch mehrere Frequenzbereiche ausgewählt werden, ja es ist sogar möglich, einen oder mehrere Teilbereiche innerhalb des Spektrogramms 21 auszuwählen, die in Zeit und Frequenz beschränkt sind.

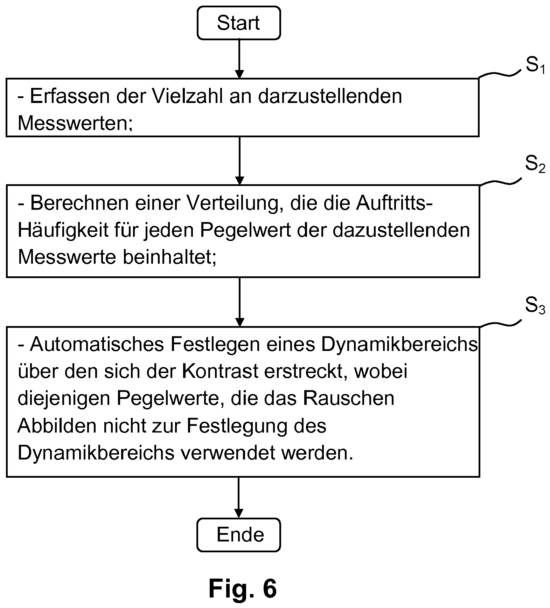

Fig. 6 beschreibt ein Flussdiagramm des erfindungsgemäßen Verfahrens zur Erhöhung eines Kontrasts von einer Vielzahl in einem Spektrogramm 21 oder spektralen Histogramm dargestellten Messwerte, aufweisend eine Messvorrichtung 1. In einem ersten Verfahrensschritt S₁ werden die Vielzahl der darzustellenden Messwerte erfasst. Dies gelingt mit der Erfassungseinheit 18, welche vorzugsweise bereits eine Dezimation der gemessenen Messwerte hin zu den darzustellenden Messwerten durchführt. Wie bereits erläutert, kann dies mit verschiedenen Detektoren (min, max, mittel) geschehen. Die darzustellenden Messwerte werden von der Erfassungseinheit 18 an die Recheneinheit 3, also die zentrale Datenverarbeitungseinheit 3, übergeben.

Anschließend wird ein zweiter Verfahrensschritt S₂ ausgeführt. Innerhalb des Verfahrensschritts S₂ wird eine Verteilung 23 berechnet, die die Auftritts-Häufigkeit für jeden Pegelwert der darzustellenden Messwerte beinhaltet. In die Berechnung der Verteilung 23 gehen insbesondere nur die darzustellenden Messwerte ein, die einen bestimmten Schwellwert bezüglich ihrer Auftritts-Häufigkeit und/oder ihres Pegelwerts überschreiten.

Im Anschluss daran wird der Verfahrensschritt S₃ ausgeführt. In dem Verfahrensschritt S₃ wird ein Dynamikbereich 24 festgelegt, über den sich der Kontrast erstreckt, wobei ein festgelegter Anteil derjenigen Pegelwerte, die das Rauschen bilden, nicht zur Festlegung des Dynamikbereichs 24 verwendet werden. Pegelwerte, die außerhalb des Dynamikbereichs 24 liegen, werden bevorzugt in zwei unterschiedlichen Farben, wie z.B. weiß oder schwarz dargestellt.

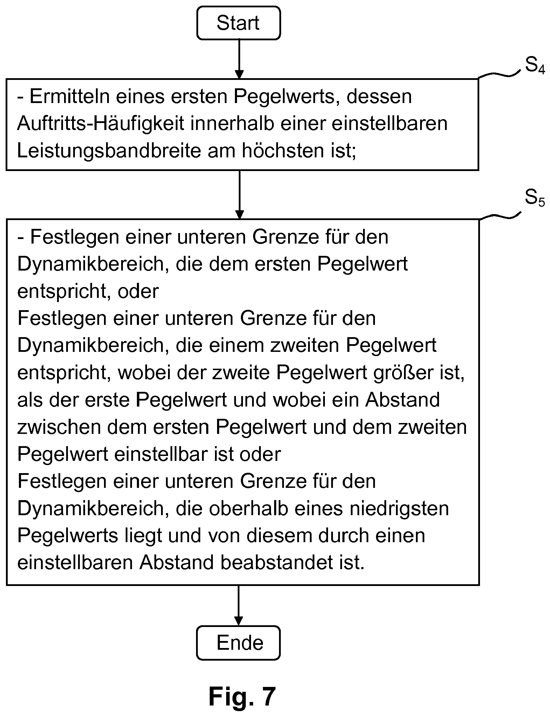

Fig. 7 beschreibt ein Flussdiagramm des erfindungsgemäßen Verfahrens zur Erhöhung des Kontrasts, in welchem angegeben wird, wie die Grenzen des Dynamikbereichs 24 gewählt werden, welcher den Kontrast bestimmt. Hierzu wird ein Verfahrensschritt S₄ ausgeführt. Innerhalb des Verfahrensschritts S₄ wird ein erster Pegelwert ermittelt, dessen Auftritts-Häufigkeit innerhalb einer einstellbaren Leistungsbandbreite am höchsten ist. Bei einem solchen Pegelwert handelt es sich in der Regel um einen Pegelwert, dessen zugehöriger Messwert das Rauschen abbildet.

Im Anschluss daran wird der Verfahrensschritt S₅ ausgeführt. Innerhalb des Verfahrensschritts S₅ wird eine untere Grenze für den Dynamikbereich 24 festgelegt, die dem ersten Pegelwert entspricht. Es ist auch möglich, dass eine untere Grenze für den Dynamikbereich 24 festgelegt wird, die einem zweiten Pegelwert entspricht, wobei der zweite Pegelwert größer ist als der erste Pegelwert und wobei ein Abstand zwischen dem ersten Pegelwert und dem zweiten Pegelwert einstellbar ist. Alternativ kann auch die untere Grenze für den Dynamikbereich 24 dadurch festgelegt werden, dass diese oberhalb des niedrigsten Pegelwerts liegt und von diesem durch einen einstellbaren Abstand beabstandet ist. Die Wahl der Abstände sollte derart gewählt werden, dass mit einer hohen Wahrscheinlichkeit einzig Messwerte außerhalb des Dynamikbereichs 24 liegen, die das Rauschen abbilden.

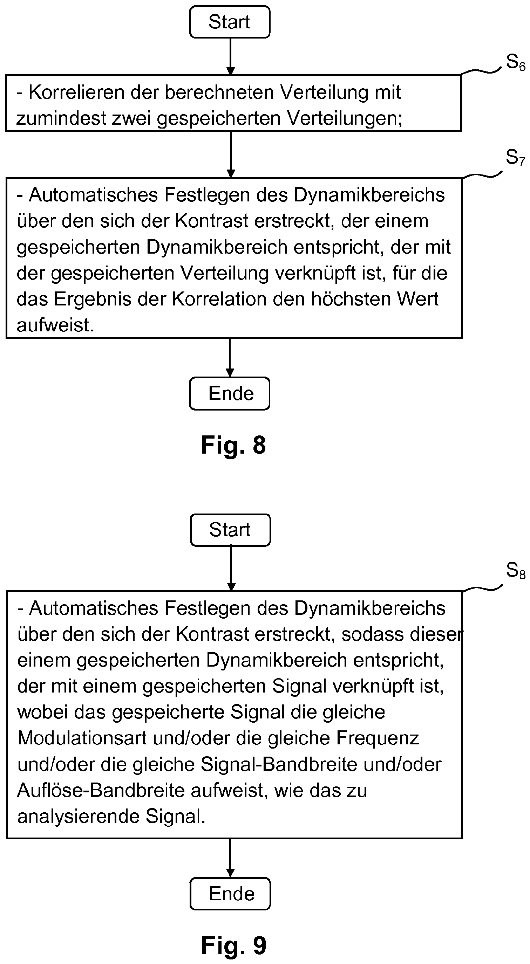

Fig. 8 zeigt ein weiteres Flussdiagramm des erfindungsgemäßen Verfahrens zur Erhöhung des Kontrasts, das beschreibt, wie die Grenzen des Dynamikbereichs 24 gewählt werden. Hierzu wird ein Verfahrensschritt S₆ ausgeführt. Innerhalb des Verfahrensschritts S₆ wird die berechnete Verteilung 23 mit zumindest zwei gespeicherten Verteilungen korreliert.

Im Anschluss daran wird der Verfahrensschritt S₇ ausgeführt. Innerhalb des Verfahrensschritts S₇ wird der Dynamikbereich 24, über den sich der Kontrast erstreckt, derart festgelegt, dass dieser einem gespeicherten Dynamikbereich entspricht, der mit der gespeicherten Verteilung verknüpft ist, für die das Ergebnis der Korrelation den höchsten Wert aufweist. Bevorzugt sind in der zumindest einen Speichereinheit 4 eine Vielzahl von Verteilungen mit dazugehörigem Dynamikbereich gespeichert.

Diese Verteilungen entsprechen beispielsweise unterschiedlichen Messsignalen, die sich beispielsweise durch die Art ihrer Modulation, ihrer Frequenz und/oder ihrer Bandbreite unterscheiden. Aus der zumindest einen Speichereinheit 4 werden dabei bevorzugt keine absoluten Werte für den Dynamikbereich 24 ausgelesen, über die er sich erstrecken soll, sondern es werden relative Werte ausgelesen, die angeben, über welche Bereiche der berechneten Verteilung 23 er sich erstrecken soll.

Fig. 9 zeigt noch ein weiteres Flussdiagramm des erfindungsgemäßen Verfahrens zur Erhöhung des Kontrasts, das beschreibt, wie die Grenzen des Dynamikbereichs 24 gewählt werden. Hierzu wird der Verfahrensschritt S₈ ausgeführt. Innerhalb des Verfahrensschritts S₈ wird der Dynamikbereich 24, über den sich der Kontrast erstreckt, automatisch festgelegt, sodass dieser einem gespeicherten Dynamikbereich entspricht, der mit einem gespeicherten Signal verknüpft ist, wobei das gespeicherte Signal die gleiche Modulationsart und/oder die gleiche Frequenz und/oder die Bandbreite aufweist, wie das zu analysierende Messsignal 7₁, 7₂. Dies geht allerdings nur dann, wenn das zu analysierende Messsignal 7₁, 7₂ zumindest grob bekannt ist.

Die Verfahrensschritte S₄, S₅, S₆, S₇, S₈ werden bevorzugt innerhalb des Verfahrensschritts S₃ ausgeführt. Die Verfahrensschritte S₄, S₅, S₆, S₇, S₈ können auch miteinander kombiniert werden. Für den Fall, dass das zu analysierende Messsignal 7₁, 7₂ bekannt ist, wird in dem Verfahrensschritt S₆ die berechnete Verteilung 23 einzig mit gespeicherten Verteilungen korreliert, die für ein gespeichertes Signal erstellt wurden, welches dieselben Eigenschaften aufweist, wie diejenigen, die für das zu analysierende Messsignal 7₁, 7₂ bekannt sind.

Die Erfindung ist nicht auf die dargestellten Ausführungsbeispiele beschränkt. Alle beschriebenen und/oder gezeichneten Elemente sind im Rahmen der Erfindung wie in den Ansprüchen definiert beliebig miteinander kombinierbar.

## Patentansprüche

1. Messvorrichtung (1) zur Erhöhung eines Kontrasts einer Vielzahl in einem Spektrogramm (21) oder spektralen Histogramm dargestellter Messwerte, die eine Erfassungseinheit (18), eine Recheneinheit (3) und eine Statistikeinheit (2) beinhaltet,
wobei die Erfassungseinheit (18) ausgebildet ist, um eine Vielzahl darzustellender Messerwerte zu erfassen,
wobei die Statistikeinheit (2) ausgebildet ist, um eine Verteilung (23) zu berechnen, die die Auftritts-Häufigkeit für jeden Pegelwert der darzustellenden Messwerte beinhaltet, und
wobei die Recheneinheit (3) ausgebildet ist, um einen Dynamikbereich (24), über den sich der Kontrast erstreckt, festzulegen, wobei ein festgelegter Anteil derjenigen Pegelwerte, die das Rauschen abbilden, nicht zur Festlegung des Dynamikbereichs (24) verwendet wird.

2. Messvorrichtung nach Anspruch 1,
**dadurch gekennzeichnet,**
**dass** der Dynamikbereich (24) einzig durch die Pegelwerte der empfangenen Messwerte gebildet ist und/oder
**dass** die Recheneinheit (3) ausgebildet ist, um einzig Pegelwerte beim Festlegen des Dynamikbereichs (24) zu berücksichtigen, deren Auftritts-Häufigkeit und/oder deren Pegelwert über einem einstellbaren Schwellwert liegen und/oder
**dass** die Recheneinheit (3) ausgebildet ist, um unterschiedliche Pegelwerte, die den Dynamikbereich (24) festlegen, durch unterschiedliche Farben und/oder durch unterschiedliche Graustufen und/oder durch unterschiedliche Helligkeitsabstufungen darzustellen.

3. Messvorrichtung nach Anspruch 2,
**dadurch gekennzeichnet,**
**dass** ein Farbverlauf und/oder ein Graustufenverlauf und/oder ein Helligkeitsabstufungsverlauf innerhalb des Dynamikbereichs (24) einen linearen oder einen nichtlinearen Verlauf, insbesondere einen parabelförmigen oder einen exponentiellen Verlauf, hat.

4. Messvorrichtung nach einem der vorherigen Ansprüche,
**dadurch gekennzeichnet,**
**dass** die Statistikeinheit (2) ausgebildet ist, um einen ersten Pegelwert zu ermitteln, dessen Auftritts-Häufigkeit innerhalb einer einstellbaren Leistungsbandbreite am höchsten ist, und
**dass** die Recheneinheit (3) ausgebildet ist, um eine untere Grenze für den Dynamikbereich (24) festzulegen, die dem ersten Pegelwert entspricht, oder
**dass** die Recheneinheit (3) ausgebildet ist, um eine untere Grenze für den Dynamikbereich (24) festzulegen, die einem zweiten Pegelwert entspricht, wobei der zweite Pegelwert größer ist als der erste Pegelwert und wobei ein Abstand zwischen dem ersten Pegelwert und dem zweiten Pegelwert einstellbar ist oder
**dass** die Recheneinheit (3) ausgebildet ist, um eine untere Grenze für den Dynamikbereich (24) festzulegen, die oberhalb eines niedrigsten Pegelwerts liegt und von diesem durch einen einstellbaren Abstand beabstandet ist.

5. Messvorrichtung nach einem der vorherigen Ansprüche,
**dadurch gekennzeichnet,**
**dass** die Recheneinheit (3) ausgebildet ist, um die berechnete Verteilung (23) mit zumindest zwei gespeicherten Verteilungen zu korrelieren und
**dass** die Recheneinheit (3) ausgebildet ist, um den Dynamikbereich (24), über den sich der Kontrast erstreckt, gemäß einem gespeicherten Dynamikbereich festzulegen, wobei der gespeicherte Dynamikbereich mit der gespeicherten Verteilung verknüpft ist, für die das Ergebnis der Korrelation den höchsten Wert aufweist.

6. Messvorrichtung nach einem der vorherigen Ansprüche,
**dadurch gekennzeichnet,**
**dass** die Vielzahl der in einem Spektrogramm (21) oder spektralen Histogramm dargestellten Messwerte zumindest ein zu analysierendes Signal (7₁, 7₂) abbilden und
**dass** die Recheneinheit (3) ausgebildet ist, um den Dynamikbereich (24), über den sich der Kontrast erstreckt, derart festzulegen, dass dieser einem gespeicherten Dynamikbereich entspricht, wobei der gespeicherte Dynamikbereich für ein Signal hinterlegt ist, das die gleiche Modulationsart und/oder die gleiche Frequenz und/oder die gleiche Signal-Bandbreite und/oder Auflöse-Bandbreite aufweist, wie das zu analysierende Signal (7₁, 7₂).

7. Messvorrichtung nach einem der vorherigen Ansprüche,
**dadurch gekennzeichnet,**
**dass** die Recheneinheit (3) ausgebildet ist, um eine Änderung einer Auflösebandbreite und/oder einer Messzeit innerhalb der Messvorrichtung (1) zu erfassen und um den Dynamikbereich (24), über den sich der Kontrast erstreckt, derart zu ändern, dass sich der Kontrast für die Vielzahl in dem Spektrogramm (21) oder spektralen Histogramm dargestellter Messwerte nicht verändert.

8. Messvorrichtung nach einem der vorherigen Ansprüche,
**dadurch gekennzeichnet,**
**dass** die Recheneinheit (3) ausgebildet ist, um den Dynamikbereich (24) über den sich der Kontrast erstreckt nur über einen oder mehrere Teilbereiche des Spektrogramms (21) oder spektralen Histogramms festzulegen.

9. Verfahren zur Erhöhung eines Kontrasts von einer Vielzahl in einem Spektrogramm (21) oder spektralen Histogramm dargestellten Messwerte, aufweisend eine Messvorrichtung (1), mit den nachfolgenden Verfahrensschritten:
- Erfassen (S₁) der Vielzahl darzustellender Messwerte;
- Berechnen (S₂) einer Verteilung (23), die die Auftritts-Häufigkeit für jeden Pegelwert der dazustellenden Messwerte beinhaltet;
- Automatisches Festlegen (S₃) eines Dynamikbereichs (24), über den sich der Kontrast erstreckt, wobei ein festgelegter Anteil derjenigen Pegelwerte, die das Rauschen abbilden, nicht zur Festlegung des Dynamikbereichs (24) verwendet werden.

10. Verfahren nach Anspruch 9,
**dadurch gekennzeichnet,**
**dass** der Dynamikbereich (24) durch die Pegelwerte der empfangenen Messwerte gebildet wird und/oder dass einzig Pegelwerte beim automatischen Festlegen des Dynamikbereichs (24) berücksichtigt werden, deren Auftritts-Häufigkeit und/oder deren Pegelwert über einem einstellbaren Schwellwert liegt und/oder
**dass** unterschiedliche Pegelwerte, die den Dynamikbereich (24) festlegen, durch unterschiedliche Farben und/oder durch unterschiedliche Graustufen und/oder durch unterschiedliche Helligkeitsabstufungen dargestellt werden.

11. Verfahren nach Anspruch 10,
**dadurch gekennzeichnet,**
**dass** ein Farbverlauf und/oder ein Graustufenverlauf und/oder ein Helligkeitsabstufungsverlauf innerhalb des Dynamikbereichs (24) einen linearen oder einen nichtlinearen Verlauf, insbesondere einen parabelförmigen oder einen exponentiellen Verlauf, hat.

12. Verfahren nach einem der Ansprüche 9 bis 11,
**gekennzeichnet durch**,
folgende Verfahrensschritte:
- Ermitteln (S₄) eines ersten Pegelwerts, dessen Auftritts-Häufigkeit innerhalb einer einstellbaren Leistungsbandbreite am höchsten ist;
- Festlegen (S₅) einer unteren Grenze für den Dynamikbereich (24), die dem ersten Pegelwert entspricht, oder
Festlegen einer unteren Grenze für den Dynamikbereich (24), die einem zweiten Pegelwert entspricht, wobei der zweite Pegelwert größer ist als der erste Pegelwert und wobei ein Abstand zwischen dem ersten Pegelwert und dem zweiten Pegelwert einstellbar ist oder
Festlegen einer unteren Grenze für den Dynamikbereich (24), die oberhalb eines niedrigsten Pegelwerts liegt und von diesem **durch** einen einstellbaren Abstand beabstandet ist.

13. Verfahren nach einem der Ansprüche 9 bis 12,
**gekennzeichnet durch**,
folgende Verfahrensschritte:
- Korrelieren (S₆) der berechneten Verteilung (23) mit zumindest zwei gespeicherten Verteilungen;
- Automatisches Festlegen (S₇) des Dynamikbereichs (24), über den sich der Kontrast erstreckt, der einem gespeicherten Dynamikbereich entspricht, der mit der gespeicherten Verteilung verknüpft ist, für die das Ergebnis der Korrelation den höchsten Wert aufweist.

14. Verfahren nach einem der Ansprüche 9 bis 13,
**dadurch gekennzeichnet,**
**dass** die Vielzahl der in einem Spektrogramm (21) oder spektralen Histogramm dargestellten Messwerte zumindest ein zu analysierendes Signal (7₁, 7₂) abbilden und der nachfolgende Verfahrensschritt ausgeführt wird:
- Automatisches Festlegen (S₈) des Dynamikbereichs (24), über den sich der Kontrast erstreckt, sodass dieser einem gespeicherten Dynamikbereich entspricht, der mit einem gespeicherten Signal verknüpft ist,
wobei das gespeicherte Signal die gleiche Modulationsart und/oder die gleiche Frequenz und/oder die gleiche Signal-Bandbreite und/oder Auflöse-Bandbreite aufweist, wie das zu analysierende Signal (7₁, 7₂).

15. Verfahren nach einem der Ansprüche 9 bis 14,
**dadurch gekennzeichnet,**
**dass** bei einer Änderung einer Auflösebandbreite und/oder einer Messzeit die Verfahrensschritte Ermitteln (S₄) und Festlegen (S₅) oder Korrelieren (S₆) und automatisches Festlegen (S₇) oder automatisches Festlegen (S₈) erneut ausgeführt werden, sodass sich der Kontrast der Vielzahl in dem Spektrogramm (21) oder spektralen Histogramm dargestellten Messwerte nicht verändert.

16. Verfahren nach einem der Ansprüche 9 bis 15,
**dadurch gekennzeichnet,**
**dass** die Verfahrensschritte Ermitteln (S₄) und Festlegen (S₅) oder Korrelieren (S₆) und automatisches Festlegen (S₇) oder automatisches Festlegen (S₈) für den Dynamikbereich (24), über den sich der Kontrast erstreckt, auch für einen oder mehrere Teilbereiche des Spektrogramm (21) oder spektralen Histogramms selektiv angewandt werden.

17. Computerprogramm mit Programmcode-Mitteln, um alle Schritte gemäß einem der Ansprüche 9 bis 16 durchführen zu können, wenn das Programm auf einem Computer oder einem digitalen Signalprozessor ausgeführt wird.

18. Computerprogramm-Produkt mit insbesondere auf einem maschinenlesbaren Träger gespeicherten Programmcode-Mitteln, um alle Schritte gemäß einem der Ansprüche 9 bis 16 durchführen zu können, wenn das Programm auf einem Computer oder einem digitalen Signalprozessor ausgeführt wird.

## Claims

1. Measuring device (1) for increasing a contrast of a multiplicity of measurements displayed in a spectrogram (21) or spectral histogram, which device comprises a registering unit (18), a computing unit (3) and a statistics unit (2),
wherein the registering unit (18) is configured to register a multiplicity of measurements to be displayed,
wherein the statistics unit (2) is configured to calculate a distribution (23) which comprises the frequency of appearance for every level value of the measurements to be displayed, and
wherein the computing unit (3) is configured to define a dynamic range (24) over which the contrast extends, wherein a defined proportion of the level values which represent the noise is not used to define the dynamic range (24).

2. Measuring device according to claim 1,
**characterised in that**
the dynamic range (24) is only formed by the level values of the measurements received and/or
**in that** the computing unit (3) is configured to take account solely of level values the frequency of appearance of which and/or the level value of which lie above an adjustable threshold value when defining the dynamic range (24) and/or
**in that** the computing unit (3) is configured to display different level values which define the dynamic range (24) by different colours and/or by different grey scales and/or by different gradations of brightness.

3. Measuring device according to claim 2,
**characterised in that**
a colour characteristic and/or a grey scale characteristic and/or a brightness gradation characteristic within the dynamic range (24) has a linear or a non-linear characteristic, in particular a parabolic or an exponential characteristic.

4. Measuring device according to one of the preceding claims,
**characterised in that**
the statistics unit (2) is configured to determine a first level value the frequency of appearance of which is at its highest within an adjustable power band width, and **in that** the computing unit (3) is configured to define a lower limit for the dynamic range (24) which corresponds to the first level value, or
**in that** the computing unit (3) is configured to define a lower limit for the dynamic range (24) which corresponds to a second level value, wherein the second level value is greater than the first level value and wherein a gap can be set between the first level value and the second level value or
**in that** the computing unit (3) is configured to define a lower limit for the dynamic range (24) which lies above a lowest level value and is separated from the latter by an adjustable gap.

5. Measuring device according to one of the preceding claims,
**characterised in that**
the computing unit (3) is configured to correlate the calculated distribution (23) with at least two stored distributions and
**in that** the computing unit (3) is configured to define the dynamic range (24) over which the contrast extends according to a stored dynamic range, wherein the stored dynamic range is associated with the stored distribution for which the correlation result has the highest value.

6. Measuring device according to one of the preceding claims,
**characterised in that**
the multiplicity of the measurements displayed in a spectrogram (21) or spectral histogram represent at least one signal (7₁, 7₂) to be analysed and
**in that** the computing unit (3) is configured to define the dynamic range (24) over which the contrast extends such that this corresponds to a stored dynamic range,
wherein the stored dynamic range is recorded for a signal which has the same type of modulation and/or the same frequency and/or the same signal band width and/or resolution band width as the signal (7₁, 7₂) to be analysed.

7. Measuring device according to one of the preceding claims,
**characterised in that**
the computing unit (3) is configured to register a change in a resolution band width and/or a measuring time within the measuring device (1) and to change the dynamic range (24) over which the contrast extends such that the contrast does not change for the multiplicity of measurements displayed in the spectrogram (21) or spectral histogram.

8. Measuring device according to one of the preceding claims,
**characterised in that**
the computing unit (3) is configured to define the dynamic range (24) over which the contrast extends solely by means of one or more part ranges of the spectrogram (21) or spectral histogram.

9. Method for increasing a contrast of a multiplicity of measurements displayed in a spectrogram (21) or spectral histogram, implementing a measuring device (1), with the following method steps:
- registration (S₁) of the multiplicity of measurements to be displayed;
- calculation (S₂) of a distribution (23) which comprises the frequency of appearance for each level value of the measurements to be displayed;
- automatic definition (S₃) of a dynamic range (24) over which the contrast extends, wherein a defined proportion of the level values which represent the noise is not used to define the dynamic range (24).

10. Method according to claim 9,
**characterised in that**
the dynamic range (24) is formed by the level values of the measurements received and/or
**in that** only level values the frequency of appearance of which and/or the level value of which lie above an adjustable threshold value are taken into account when automatically defining the dynamic range (24) and/or
**in that** different level values which define the dynamic range (24) are displayed by different colours and/or by different grey scales and/or by different gradations of brightness.

11. Method according to claim 10,
**characterised in that**
a colour characteristic and/or a grey scale characteristic and/or a brightness gradation characteristic within the dynamic range (24) have a linear or a non-linear characteristic, in particular a parabolic or an exponential characteristic.

12. Method according to one of claims 9 to 11,
**characterised by**
the following method steps:
- determination (S₄) of a first level value the frequency of appearance of which is at its highest within an adjustable power band width;
- definition (S₅) of a lower limit for the dynamic range (24) which corresponds to the first level value, or definition of a lower limit for the dynamic range (24) which corresponds to a second level value, wherein the second level value is greater than the first level value and wherein a gap can be set between the first level value and the second level value or
definition of a lower limit for the dynamic range (24) which lies above a lowest level value and is separated from the latter by an adjustable gap.

13. Method according to one of claims 9 to 12,
**characterised by**
the following method steps:
- correlation (S₆) of the calculated distribution (23) with at least two stored distributions;
- automatic definition (S₇) of the dynamic range (24) over which the contrast extends which corresponds to a stored dynamic range which is associated with the stored distribution for which the correlation result has the highest value.

14. Method according to one of claims 9 to 13,
**characterised in that**
the multiplicity of the measurements displayed in a spectrogram (21) or spectral histogram represent at least one signal (7₁, 7₂) to be analysed and the following method step is carried out:
- automatic definition (S₈) of the dynamic range (24) over which the contrast extends so that this corresponds to a stored dynamic range which is associated with a stored signal, wherein the stored signal has the same type of modulation and/or the same frequency and/or the same signal band width and/or resolution band width as the signal (7₁, 7₂) to be analysed.

15. Method according to one of claims 9 to 14,
**characterised in that**
if there is a change in a resolution band width and/or a measuring time, the method steps of Determination (S₄) and Definition (S₅) or Correlation (S₆) and Automatic definition (S₇) or Automatic definition (S₈) are carried out again so that the contrast of the multiplicity of measurements displayed in the spectrogram (21) or spectral histogram does not change.

16. Method according to one of claims 9 to 15,
**characterised in that**
the method steps of Determination (S₄) and Definition (S₅) or Correlation (S₆) and Automatic definition (S₇) or Automatic definition (S₈) for the dynamic range (24) over which the contrast extends are also used selectively for one or more part ranges of the spectrogram (21) or spectral histogram.

17. Computer program with program code means in order to be able to carry out all the steps according to one of claims 9 to 16 when the program is implemented on a computer or a digital signal processor.

18. Computer program product with in particular program code means stored on a machine-readable data storage medium in order to be able to carry out all the steps according to one of claims 9 to 16 when the program is implemented on a computer or a digital signal processor.

## Revendications

1. Dispositif de mesure (1) destiné à augmenter un contraste d'une pluralité de valeurs de mesure représentées dans un spectrogramme (21) ou un histogramme spectral, lequel dispositif comporte une unité d'acquisition (18), une unité de calcul (3) et une unité statistique (2),
dans lequel l'unité d'acquisition (18) est conçue pour acquérir une pluralité de valeurs de mesure à visualiser,
dans lequel l'unité statistique (2) est conçue pour calculer une distribution (23) qui comporte la fréquence d'occurrence pour chaque valeur de niveau des valeurs de mesure à visualiser, et
dans lequel l'unité de calcul (3) est conçue pour définir une plage dynamique (24) sur laquelle s'étend le contraste, une part définie des valeurs de niveau qui représentent le bruit n'étant pas utilisée pour définir la plage dynamique (24).

2. Dispositif de mesure selon la revendication 1,
**caractérisé**
**en ce que** la plage dynamique (24) est formée uniquement par les valeurs de niveau des valeurs de mesure reçues et/ou
**en ce que** l'unité de calcul (3) est conçue, lors de la définition de la plage dynamique (24), pour ne prendre en compte que les valeurs de niveau dont la fréquence d'occurrence et/ou dont la valeur de niveau se situent au-dessus d'une valeur seuil ajustable, et/ou
**en ce que** l'unité de calcul (3) est conçue pour visualiser différentes valeurs de niveau, qui définissent la plage dynamique (24), au moyen de différentes couleurs et/ou au moyen de différents niveaux de gris et/ou au moyen de différentes gradations de luminosité.

3. Dispositif de mesure selon la revendication 2,
**caractérisé**
**en ce qu'**une variation de couleur et/ou une variation de niveau de gris et/ou une variation de gradation de luminosité présentent à l'intérieur de la plage dynamique (24) un tracé linéaire ou non linéaire, en particulier un tracé parabolique ou un tracé exponentiel.

4. Dispositif de mesure selon l'une quelconque des revendications précédentes,
**caractérisé**
**en ce que** l'unité statistique (2) est conçue pour déterminer une première valeur de niveau dont la fréquence d'occurrence d'une bande de puissance ajustable est la plus élevée, et
**en ce que** l'unité de calcul (3) est conçue pour définir une limite inférieure pour la plage dynamique (24), laquelle limite correspond à la première valeur de niveau, ou
**en ce que** l'unité de calcul (3) est conçue pour définir une limite inférieure pour la plage dynamique (24), laquelle limite correspond à une deuxième valeur de niveau, la deuxième valeur de niveau étant supérieure à la première valeur de niveau et un écart entre la première valeur de niveau et la deuxième valeur de niveau étant ajustable ou
**en ce que** l'unité de calcul (3) est conçue pour définir une limite inférieure pour la plage dynamique (24), laquelle limite se situe au-dessus de la plus basse valeur de niveau et est espacée de celle-ci d'un écart ajustable.

5. Dispositif de mesure selon l'une quelconque des revendications précédentes,
**caractérisé**
**en ce que** l'unité de calcul (3) est conçue pour corréler la distribution (23) calculée à au moins deux distributions mises en mémoire et
**en ce que** l'unité de calcul (3) est conçue pour définir la plage dynamique (24) sur laquelle le contraste s'étend, conformément à une plage dynamique mise en mémoire,
dans lequel la plage dynamique mise en mémoire est combinée à la distribution mise en mémoire pour laquelle le résultat de la corrélation présente la valeur la plus élevée.

6. Dispositif de mesure selon l'une quelconque des revendications précédentes,
**caractérisé**
**en ce que** la pluralité des valeurs de mesure visualisées dans un spectrogramme (21) ou un histogramme spectral représentent au moins un signal (7₁, 7₂) à analyser et
**en ce que** l'unité de calcul (3) est conçue pour définir la plage dynamique (24) sur laquelle le contraste s'étend, de telle manière que celle-ci corresponde à une plage dynamique mise en mémoire, la plage dynamique mise en mémoire étant enregistrée pour un signal qui présente le même type de modulation et/ou la même fréquence et/ou la même largeur de bande de signal et/ou largeur de bande de résolution que ceux du signal (7₁, 7₂) à analyser.

7. Dispositif de mesure selon l'une quelconque des revendications précédentes,
**caractérisé**
**en ce que** l'unité de calcul (3) est conçue pour acquérir une modification d'une largeur de bande de résolution et/ou d'une durée de mesure à l'intérieur du dispositif de mesure (1) et pour modifier la plage dynamique (24) sur laquelle le contraste s'étend, de telle manière que le contraste pour la pluralité de valeurs de mesure visualisées dans le spectrogramme (21) ou l'histogramme spectral ne varie pas.

8. Dispositif de mesure selon l'une quelconque des revendications précédentes,
**caractérisé**
**en ce que** l'unité de calcul (3) est conçue pour définir la plage dynamique (24) sur laquelle le contraste s'étend uniquement sur une ou plusieurs parties du spectrogramme (21) ou de l'histogramme spectral.

9. Procédé d'augmentation d'un contraste d'une pluralité de valeurs de mesure visualisées dans un spectrogramme (21) ou un histogramme spectral, comportant un dispositif de mesure (1), le procédé comprenant les étapes de procédé suivantes :
- l'acquisition (S₁) de la pluralité de valeurs de mesure à visualiser ;
- le calcul (S₂) d'une distribution (23), qui comporte la fréquence d'occurrence pour chaque valeur de niveau des valeurs de mesure à visualiser ;
- la définition automatique (S₃) d'une plage dynamique (24), sur laquelle le contraste s'étend, une part définie des valeurs de niveau qui représentent le bruit n'étant pas utilisée pour définir la plage dynamique (24).

10. Procédé selon la revendication 9,
**caractérisé**
**en ce que** la plage dynamique (24) est formée par les valeurs de niveau des valeurs de mesure reçues et/ou
**en ce que** seules des valeurs de niveau dont la fréquence d'occurrence et/ou la valeur de niveau se situent au-dessus d'une valeur seuil ajustable sont prises en compte lors de la définition automatique de la plage dynamique (24) et/ou
**en ce que** différentes valeurs de niveau, qui définissent la plage dynamique (24), sont visualisées au moyen de différentes couleurs et/ou au moyen de différents niveaux de gris et/ou au moyen de différentes gradations de luminosité.

11. Procédé selon la revendication 10,
**caractérisé**
**en ce qu'**une variation de couleur et/ou une variation de niveau de gris et/ou une variation de gradation de luminosité présentent à l'intérieur de la plage dynamique (24) un tracé linéaire ou non linéaire, en particulier un tracé parabolique ou un tracé exponentiel.

12. Procédé selon l'une quelconque des revendications 9 à 11,
**caractérisé par**
les étapes de procédé suivantes :
- la détermination (S₄) d'une première valeur de niveau dont la fréquence d'occurrence à l'intérieur d'une bande de puissance ajustable est la plus élevée ;
- la définition (S₅) d'une limite inférieure pour la plage dynamique (24), laquelle limite correspond à la première valeur de niveau, ou
la définition d'une limite inférieure pour la plage dynamique (24), laquelle limite correspond à une deuxième valeur de niveau, la deuxième valeur de niveau étant supérieure à la première valeur de niveau et un écart entre la première valeur de niveau et la deuxième valeur de niveau étant ajustable ou
la définition d'une limite inférieure pour la plage dynamique (24), laquelle limite se situe au-dessus de la plus basse valeur de niveau et est espacée de celle-ci d'un écart ajustable.

13. Procédé selon l'une quelconque des revendications 9 à 12,
**caractérisé par**
les étapes de procédé suivantes :
- la corrélation (S₆) de la distribution (23) calculée à au moins deux distributions mises en mémoire ;
- la définition automatique (S₇) de la plage dynamique (24) sur laquelle le contraste s'étend, qui correspond à une plage dynamique mise en mémoire, qui est combinée à la distribution mise en mémoire pour laquelle le résultat de la corrélation présente la valeur la plus élevée.

14. Procédé selon l'une quelconque des revendications 9 à 13,
**caractérisé**
**en ce que** la pluralité des valeurs de mesure visualisées dans un spectrogramme (21) ou un histogramme spectral représentent au moins un signal (7₁, 7₂) à analyser et l'étape de procédé suivante est mise en oeuvre :
- la définition automatique (S₈) de la plage dynamique (24) sur laquelle le contraste s'étend, de sorte que celle-ci corresponde à une plage dynamique mise en mémoire, qui est combinée à un signal mis en mémoire, le signal mis en mémoire présentant le même type de modulation et/ou la même fréquence et/ou la même largeur de bande de signal et/ou largeur de bande de résolution que ceux du signal (7₁, 7₂) à analyser.

15. Procédé selon l'une quelconque des revendications 9 à 14,
**caractérisé**
**en ce que**, lors d'une modification d'une largeur de bande de résolution et/ou d'une durée de mesure, les étapes de procédé détermination (S₄) et définition (S₅) ou corrélation (S₆) et définition automatique (S₇) ou définition automatique (S₈) sont à nouveau mises en oeuvre, de sorte que le contraste de la pluralité de valeurs de mesure visualisées dans le spectrogramme (21) ou l'histogramme spectral ne varie pas.

16. Procédé selon l'une quelconque des revendications 9 à 15,
**caractérisé**
**en ce que** les étapes de procédé détermination (S₄) et définition (S₅) ou corrélation (S₆) et définition automatique (S₇) ou définition automatique (S₈) pour la plage dynamique (24), sur laquelle s'étend le contraste, sont également appliquées de manière sélective pour une ou plusieurs parties du spectrogramme (21) ou de l'histogramme spectral.

17. Programme informatique comprenant des moyens de code de programme, afin de pouvoir réaliser toutes les étapes selon l'une quelconque des revendications 9 à 16, lorsque le programme est exécuté sur un ordinateur ou un processeur de signal numérique.

18. Produit-programme informatique comprenant en particulier des moyens de code de programme mis en mémoire sur un support lisible par ordinateur, afin de pouvoir réaliser toutes les étapes selon l'une des revendications 9 à 16, lorsque le programme est exécuté sur un ordinateur ou un processeur de signal numérique.
